# EUROPEAN PATENT APPLICATION

(11) **EP 4 485 512 A1**
(43) Date of publication of application: **01.01.2025**
(21) Application number: 24165780.8
(22) Date of filing: 25.03.2024
(51) Int. Cl.: H01L 21/67, H01L 21/673

(54) **TEMPERATURE SENSOR, SUBSTRATE PROCESSING APPARATUS, METHOD OF MANUFACTURING SEMICONDUCTOR DEVICE, AND TEMPERATURE CONTROL SYSTEM**

(30) Priority: 27.06.2023 JP 2023105293
(71) Applicant: Kokusai Electric Corp., Tokyo 1010045 (JP)
(72) Inventor: NAKADA, Takayuki, Toyama-shi, Toyama 939-2393 (JP); MURATA, Hitoshi, Toyama-shi, Toyama 939-2393 (JP); NAKANISHI, Kento, Toyama-shi, Toyama 939-2393 (JP)
(74) Representative: Bardehle Pagenberg Partnerschaft mbB Patentanwälte Rechtsanwälte

(57) **Abstract**

There is provided a technique that includes: a temperature measurer (211b) disposed in a processing space formed between substrates (1) supported by supports (35) of a substrate support (31); a detector (2111) in which the temperature measurer (211b) is provided; and a column (2112) extending in a vertical direction so as to support the detector (2111) in a horizontal direction, wherein a lower end of the detector (2111) is arranged at a same height position as a lower end of each of the supports (35) or at a higher position than the lower end of each of the supports (35), and wherein a surface of the column (2112) near the processing space is arranged farther from the processing space than a surface of a support column (34) near the processing space, the support column (34) being configured to support each of the supports (35) in the horizontal direction.

## Description

### CROSS-REFERENCE TO RELATED APPLICATION

This application is based upon and claims the benefit of priority from Japanese Patent Application No. 2023-105293, filed on June 27, 2023, the entire contents of which are incorporated herein by reference.

### TECHNICAL FIELD

The present disclosure relates to a temperature sensor, a substrate processing apparatus, a method of manufacturing a semiconductor device, and a temperature control system.

### BACKGROUND

As a process of manufacturing a semiconductor device, a predetermined process is sometimes performed on a wafer (hereinafter also referred to as a substrate). In the related art, there is known a technique of controlling a temperature in a process chamber by using a temperature detected by a temperature sensor that moves together with a boat (hereinafter also referred to as a substrate support). However, in a case where the temperature sensor is disposed in a processing space, it may interfere with various processes performed on a substrate.

### SUMMARY

Some embodiments of the present disclosure provide a technique capable of arranging a temperature sensor within a processing space where a substrate is processed, without affecting various processes performed on the substrate.

According to some embodiments of the present disclosure, there is provided a technique that includes: a temperature measurer disposed in a processing space formed between substrates supported by supports of a substrate support; a detector in which the temperature measurer is provided; and a column extending in a vertical direction so as to support the detector in a horizontal direction, wherein a lower end of the detector is arranged at a same height position as a lower end of each of the supports or at a higher position than the lower end of each of the supports, and wherein a surface of the column near the processing space is arranged farther from the processing space than a surface of a support column near the processing space, the support column being configured to support each of the supports in the horizontal direction.

### BRIEF DESCRIPTION OF DRAWINGS

The accompanying drawings, which are incorporated in and constitute a part of the specification, illustrate embodiments of the present disclosure.
FIG. 1 is a vertical cross-sectional view schematically showing a substrate processing apparatus according to embodiments of the present disclosure.
FIG. 2 is a schematic diagram for explaining first to third temperature sensors according to embodiments of the present disclosure.
FIG. 3A is a side view for explaining a positional relationship between a first temperature sensor and a substrate support according to embodiments of the present disclosure. FIG. 3B is a top view for explaining a positional relationship between a first temperature sensor and a substrate support according to embodiments of the present disclosure.
FIG. 4 is a perspective view showing a state in which a first temperature sensor according to embodiments of the present disclosure is attached to a substrate support.
FIG. 5A is a perspective view showing an upper end connector attached to an upper end of the first temperature sensor according to embodiments of the present disclosure. FIG. 5B is a side view of the upper end connector shown in FIG. 5A.
FIG. 6 is a vertical cross-sectional view schematically showing a periphery of a rotator in a substrate processing apparatus according to embodiments of the present disclosure.
FIG. 7 is a diagram showing a hardware configuration of a controller in the substrate processing apparatus according to embodiments of the present disclosure.
FIG. 8 is a diagram showing a hardware configuration of a temperature controller in a substrate processing apparatus according to embodiments of the present disclosure.
FIG. 9A is a diagram for explaining a substrate processing sequence performed by a substrate processing apparatus according to embodiments of the present disclosure. FIG. 9B is a diagram showing temperature changes at respective steps of s substrate processing sequence shown in FIG. 9A.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

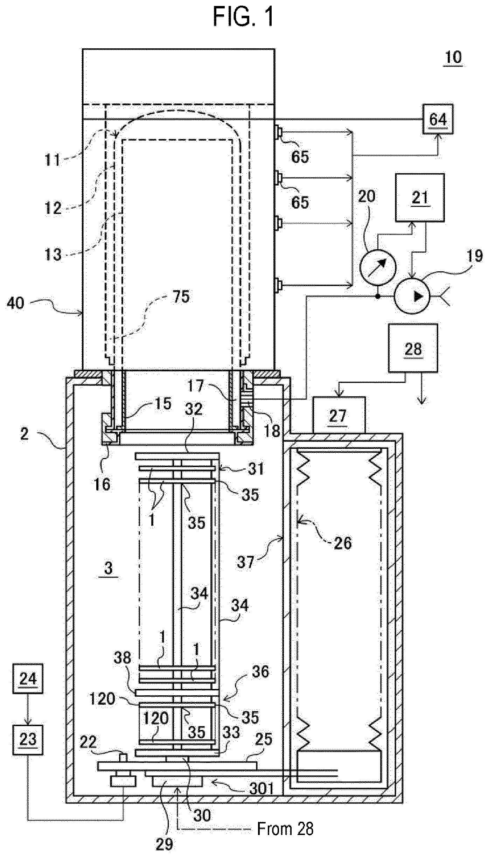

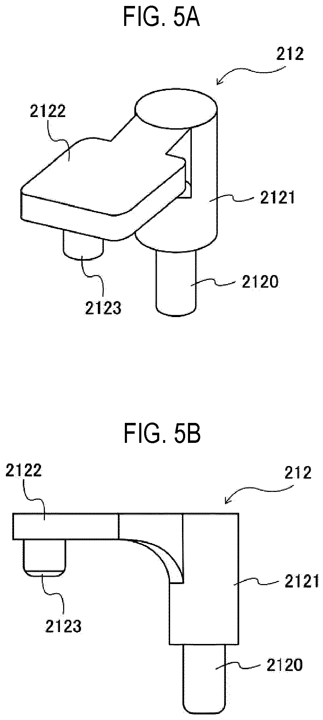

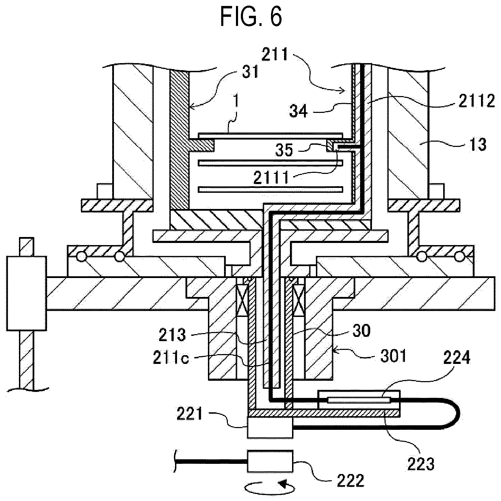

Embodiments of the present disclosure will be described below mainly with reference to FIGS. 1 to 9B. The drawings used in the following description are schematic, and dimensional relationships, ratios, and the like of the respective components shown in the drawings may not match actual ones. Furthermore, even among multiple drawings, dimensional relationships, ratios, and the like of the respective components may not match one another. In addition, among multiple drawings, substantially the same components are designated by like reference numerals. Each component will be described in the drawing in which the component first appears, and the description will be omitted in subsequent drawings unless it is demanded particularly. Unless otherwise specified in the present disclosure, each component is not limited to one component, and a plurality of components may exist.

### (1) Configuration of Substrate Processing Apparatus

A configuration of a substrate processing apparatus 10 will be described with reference to FIG. 1.

As shown in FIG. 1, the substrate processing apparatus 10 includes a supported vertical reaction tube (process tube) 11, and the reaction tube 11 includes an outer tube 12 and an inner tube 13 arranged concentrically with each other. The outer tube 12 is made of quartz (SiO₂) and is integrally formed in a cylindrical shape with an upper closed end and a lower end closed. The inner tube 13 is formed in a cylindrical shape with both upper and lower ends opened. A process chamber 14 is formed in a cylindrical hollow region of the inner tube 13, and a boat 31 as a substrate support (also referred to as a substrate holder or a holder) is loaded into the process chamber 14. A lower end (open space) of the inner tube 13 forms a furnace opening 15 through which a boat 31 is taken in and out.

A lower end between the outer tube 12 and the inner tube 13 is hermetically sealed by a manifold 16 formed in a substantially cylindrical shape and serving as a furnace opening flange. The manifold 16 is detachably attached to the outer tube 12 and the inner tube 13 for replacement of the outer tube 12 and the inner tube 13, or the like.

Due to a gap between the outer tube 12 and the inner tube 13, an exhaust passage 17 is formed in a circular ring shape with a constant width in cross section. As shown in FIG. 1, one end of an exhaust pipe 18 is connected to an upper side of a side wall of the manifold 16. The exhaust pipe 18 is in fluid communication with the lowermost end of the exhaust passage 17. An exhauster 19 controlled by a pressure controller 21 is connected to the other end of the exhaust pipe 18, and a pressure sensor 20 is connected to the exhaust pipe 18 in the middle of the exhaust pipe 18. The pressure controller 21 is configured to feedback-control the exhauster 19 based on measurement results from the pressure sensor 20.

A lid (seal cap) 25 configured to close a lower end opening of the manifold 16 is in contact with the manifold 16 from a lower side in a vertical direction. A lid 25 is formed in a disc shape with a diameter approximately equal to an outer diameter of the manifold 16. The lid 25 is configured to be raised or lowered in the vertical direction by an elevator (boat elevator) 26 protected by a boat cover 37 installed in a delivery chamber (transfer chamber) 3 of a housing 2. Thus, the boat 31 may move between the process chamber 14 and the transfer chamber 3 provided below and adjacent to the process chamber 14. The elevator 26 is constituted by a motor-driven feed screw shaft apparatus, a bellows, and the like, and a motor 27 of the elevator 26 is configured to be controlled by a drive controller 28. A rotary shaft 30 is disposed on a center line of the lid 25 and is rotatably supported. The rotary shaft 30 is configured to be rotationally driven by a motor 29 controlled by a drive controller 28. The boat 31 is vertically supported at an upper end of the rotary shaft 30. In the embodiments of the present disclosure, the rotary shaft 30 and the motor 29 constitute a rotator 301. That is, the rotator 301 is configured to rotate the boat 31.

A gas introduction pipe 22 is arranged in the lid 25 located below the manifold 16 so as to be in fluid communication with the furnace opening 15 of the inner pipe 13. A precursor gas supplier, a reaction gas supplier, and an inert gas supplier (hereinafter, collectively referred to as a gas supplier 23) are connected to the gas introduction pipe 22. The gas supplier 23 is configured to be controlled by a gas flow rate controller 24. The gas introduced into the furnace opening 15 from the gas introduction pipe 22 flows through the process chamber 14 of the inner pipe 13, passes through the exhaust passage 17, and is exhausted via the exhaust pipe 18.

The boat 31 includes a pair of upper and lower end plates 32 and 33, and support columns (columns) 34 as three support columns vertically installed between the end plates. The three support columns 34 are provided with supports 35 as a large number of holding grooves, which are formed at equal intervals in the longitudinal direction and configured to support the substrates 1. The supports 35 of the three support columns 34 provided at the same level are open to face one another. The boat 31 is configured to hold a plurality of substrates 1 horizontally with centers of the substrates 1 aligned with one another by inserting the substrates 1 among the supports 35 of the three support columns 34 on the same level. Further, by inserting heat insulating plates 120 among the supports 35 of the three support columns 34 on the same level, the plurality of heat insulating plates 120 may be held horizontally with centers of the heat insulating plates 120 aligned with one another.

In other words, the boat 31 is configured to distinguish a substrate processing region between the end plates 32 and 38 where a plurality of substrates 1 are held from a heat insulating plate region between the end plates 38 and 33 where a plurality of heat insulating plates 120 are held. The heat insulating plate region is arranged below the substrate processing region. A heat insulator 36 is constituted by the heat insulating plates 120 held between the end plates 38 and 33.

The rotary shaft 30 is configured to support the boat 31 in a state in which the boat 31 is lifted from an upper surface of the lid 25. The heat insulator 36 is installed at the furnace opening 15 and is configured to insulate the furnace opening 15. Further, a motor 29 configured to rotate the boat 31 is arranged under the lid 25. The motor 29 is formed with a hollow motor structure. The rotary shaft 30 passes through the motor 29.

A heater 40 serving as a heating equipment is arranged concentrically outside the reaction tube 11. The heater 40 is installed by being supported on the housing 2.

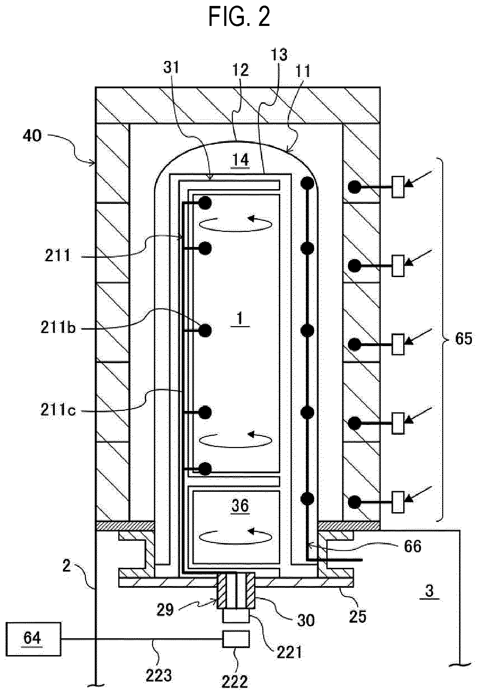

As shown in FIG. 2, the heater 40 is configured such that a plurality of heaters are respectively provided for a plurality of zones and are stacked one above another so that the heater 40 may divisionally control the heaters for the plurality of zones in the vertical direction. That is, the heater 40 includes a plurality of heating regions where the substrates 1 are heated. The heater 40 is, for example, divided into five zones, U, CU, C, CL, and L, sequentially from the top. A substrate thermocouple 211 as a first temperature sensor, an internal thermocouple 66 as a second temperature sensor, and a heater thermocouple 65 as a third temperature sensor are installed in each zone. In FIG. 2, the substrates are indicated as "1" and are not shown.

The heater thermocouple 65 is provided near the heater 40 and is configured to measure a temperature of the heater for each zone. The temperature controller 64 is configured to feedback-control the heater 40 based on measurement results from the heater thermocouple 65. Thus, the heater 40 is configured to heat the substrates 1 held by the boat 31 in the substrate processing region.

The internal thermocouple 66 is provided inside the outer tube 12 between the inner tube 13 and the outer tube 12 and is configured to measure a temperature between the inner tube 13 and the outer tube 12. The internal thermocouple 66 is formed in a structure in which a number of thermocouples corresponding to the number of zones are accommodated in one protection tube, and a temperature measurer configured to measure a temperature is provided at a position facing each zone. In the same manner as the heater thermocouple 65, the temperature controller 64 is configured to feedback-control the heater 40 based on measurement results from the internal thermocouple 66.

The substrate thermocouple 211 is attached to the boat 31 and is arranged near the substrates 1 to measure the temperature of the substrates 1. Although described in detail later, the substrate thermocouple 211 includes a temperature measurer 211b configured to measure the temperature of the substrates 1, and a cable 211c including a wire that forms the temperature measurer 211b. As shown in FIG. 2, an example is shown in which the temperature measurer 211b is provided at a position facing each of the zones. The substrate thermocouple 211 is configured to rotate together with the substrates 1 when the boat 31 rotates to rotate the substrates 1. Further, the substrate thermocouple 211 is configured to move up or down together with the substrates 1 when the boat 31 moves up or down. That is, the temperature measurer 211b is attached so as to operate together with the boat 31. In the same manner as the heater thermocouple 65 and the internal thermocouple 66, the temperature controller 64 is configured to feedback-control the heater 40 based on measurement results from the substrate thermocouple 211.

That is, the heater 40 is configured such that the temperature measurer of each of the substrate thermocouple 211, the internal thermocouple 66, and the heater thermocouple 65 is provided at each heating region facing the substrates 1. In other words, the substrate thermocouple 211, the internal thermocouple 66, and the heater thermocouple 65 are arranged such that heights of the temperature measurers of the substrate thermocouple 211, the internal thermocouple 66, and the heater thermocouple 65 are approximately equal to one another. Therefore, the temperatures of the substrates 1 arranged in each heating region may be accurately measured. The substrate thermocouple 211, the internal thermocouple 66, and the heater thermocouple 65 may be of any type as long as they may measure a temperature as an electrical signal. The substrate thermocouple 211, the internal thermocouple 66, and the heater thermocouple 65 are not limited to thermocouples but may be other sensors such as a temperature measurement resistor and the like. Further, as a temperature sensor other than the substrate thermocouple 211, either the internal thermocouple 66 or the heater thermocouple 65 may be used.

The rotary shaft 30 includes a hole through which a cable 211c passes, and the cable 211c is drawn to a transmitter 221 outside the process chamber 14 (e.g., below the rotary shaft 30) while maintaining vacuum-sealing by using a hermetic seal or the like.

A transmitter 221 and a receiver 222 are arranged in the delivery chamber 3 outside the processing space. The transmitter 221 is fixed coaxially with the center of the rotary shaft 30, and is configured to rotate and move up or down together with the rotary shaft 30. That is, the transmitter 221 is connected to the substrate thermocouple 211 outside the process chamber 14 in which the substrates 1 are processed, and is configured to rotate and move up or down together with the boat 31. The transmitter 221 is configured to be capable of transmitting an electrical signal (voltage), which is inputted from the substrate thermocouple 211 via the cable 211c, over radio waves by wireless transmission.

Further, the receiver 222 is arranged in the immediate vicinity of the transmitter 221. The receiver 222 is configured to receive a signal outputted from the transmitter 221. Although the receiver 222 is provided at the delivery chamber 3, the present disclosure is not limited thereto. The receiver 222 may be arranged outside the delivery chamber 3 or may be arranged at a position spaced apart from the substrate processing apparatus 10.

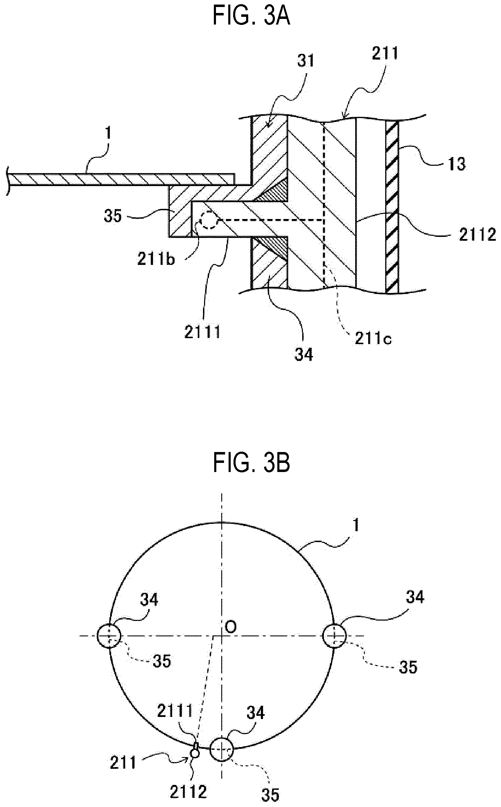

Next, the substrate thermocouple 211 will be described in detail with reference to FIGS. 3A and 3B.

The substrate thermocouple 211 includes a temperature measurer 211b, a detector 2111 in which the temperature measurer 211b is provided, and a column 2112 extending in the vertical direction to support the detector 2111 horizontally. The detector 2111 and the column 2112 is formed in, for example, a cylindrical shape, and are configured to allow the temperature measurer 211b and the cable 211c to pass therethrough. Thus, the temperature measurer 211b and the cable 211c may be isolated from the processing space. The detector 2111 and the column 2112 are, for example, integrally formed. The detector 2111 and the column 2112 are made of the same material of good heat resistance, for example, quartz. When the detector 2111 and the column 2112 are made of the same material as the boat 31, for example, quartz, it is possible to reduce an influence on substrate processing. Therefore, the temperature of the substrate 1 may be accurately measured, and a time for controlling the substrate temperature during substrate processing may be significantly shortened.

A lower end of the detector 2111 is configured to be arranged at the same height position as a lower end of the support 35 or at a higher position than the lower end of the support 35. Further, a surface of the column 2112 near the processing space and the substrate 1 is arranged farther from the processing space, i.e., the substrates 1, than a surface of the support column 34 configured to support the support 35 in the horizontal direction near the processing space and the substrate 1. At least one or more (five, in FIG. 2) detectors 2111 are provided at regions of the processing space where the substrates 1 are arranged. Since the detectors 2111 are arranged in the processing space, it is possible to accurately measure the temperatures of the substrates 1.

The temperature measurer 211b is configured to be arranged in the processing space formed between the substrates 1 supported by the supports 35 of the boat 31. Further, the temperature measurer 211b is arranged at a periphery of the substrate 1 near a rear surface of the substrate 1. Specifically, the temperature measurer 211b is arranged at an inner side of the substrate 1 (also referred to as near a center of the substrate 1) than a peripheral edge of the substrate 1. Further, the temperature measurer 211b is arranged in the vicinity of the support column 34. As used herein, an expression "in the vicinity of the support column 34" means that the temperature measurer 211b is arranged at a position closer to the support column 34 than an intermediate position between the support column 34 and the center of the substrate 1 in a state in which the substrate 1 is held on the support 35. In this way, the substrate thermocouple 211 (temperature measurer 211b) is arranged in a space where the substrate 1 is processed (a space between the substrates). Therefore, it is possible to measure the temperature of the processing space closer to the substrate 1 than the heater thermocouple 65 or the internal thermocouple 66. Accordingly, it is possible to more accurately measure the temperature of the substrate 1 and to significantly shorten the control time.

As shown in FIG. 3A, in a side view of the support 35, the detector 2111 is arranged at a position included inside an outer contour of the support 35. That is, in a side view of the support 35, the detector 2111 is configured to be smaller than the outer contour of the support 35. Further, a cross-sectional area of the detector 2111 is set to be smaller than a cross-sectional area of the support 35.

As shown in FIG. 3A, the detector 2111 and the support 35 extend to an inner side of the substrate 1 than the periphery of the substrate 1. The support 35 is configured to extend to an inner side of the substrate 1 than the detector 2111. An amount of extension of the detector 2111 from the periphery to the inner side of the substrate 1 is set to be smaller than an amount of extension of the support 35 from the periphery to the inner side of the substrate 1. That is, a tip of the detector 2111 is arranged to be located between a tip of the support 35 and the periphery of the substrate 1.

Further, as shown in FIG. 3B, in a plane view of the substrate 1 viewed from above, the detector 2111 is arranged at a position where a longitudinal extension line of the detector 2111 does not overlap with the center O of the substrate 1. In other words, the longitudinal direction of the detector 2111 makes an angle other than 0 degrees with respect to the center direction of the substrate 1. Further, the detector 2111 may be arranged at such an angle that the longitudinal direction of the detector 2111 extends along the peripheral edge of the substrate 1. As a result, the detector 2111 may be brought closer to the substrate 1, and the substrate thermocouple 211 may be accommodated in a narrow space.

FIGS. 3A and 3B are diagrams showing an example in which in a side view of the support 35, the detector 2111 is arranged at a position included inside the outer contour of the support 35. As described above, the lower end of the detector 2111 may be located at the same height position as the lower end of the support 35 or at a higher position than the lower end of the support 35. Therefore, the longitudinal extension line of the detector 2111 may face the center O of the substrate 1.

By adopting the configuration in which the lower end of the detector 2111 is arranged at the same height position as the lower end of the support 35 or at a higher position than the lower end of the support 35 as described above, it is possible to avoid contact (interference) between the substrate 1 and the substrate thermocouple 211 when transferring the substrate 1 together with the boat 31. Accordingly, it is possible to perform a transfer between the substrate 1 and the boat 31 regardless of whether the substrate thermocouple 211 is arranged or not. Further, it is possible to reduce an influence of an arrangement position of the substrate thermocouple 211 on the processing of the substrate 1. In particular, by adopting the configuration in which the detector 2111 is arranged at a position included inside the outer contour of the support 35 as shown in FIGS. 3A and 3B, it is possible to expect an effect of reducing the influence on the processing of the substrate 1.

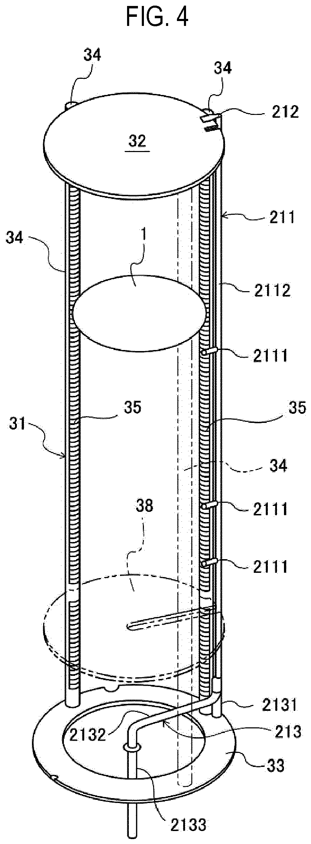

Next, how the substrate thermocouple 211 according to the embodiments of the present disclosure is attached to the boat 31 will be described with reference to FIGS. 4 to 6.

The substrate thermocouple 211 is arranged in the vicinity of the support column 34 of the boat 31 so as to extend upward in a direction in which the substrates 1 are arranged. An upper end connector 212 is provided at the upper end of the column 2112. The upper end connector 212 is configured to connect the substrate thermocouple 211 to the end plate 32 of the boat 31. Further, a lower end connector 213 is provided at the lower end of the column 2112. The lower end connector 213 is configured to connect the substrate thermocouple 211 to the end plate 33 of the boat 31.

That is, the substrate thermocouple 211 is configured to be attached to the boat 31 via the upper end connector 212 and the lower end connector 213. Therefore, the detector 2111 and the column 2112 are configured so as not to come into contact with the boat 31, and are configured so as not to affect the temperature of the substrates 1. As a result, it is possible to reduce the influence on the processing of the substrate 1 and to significantly shorten the time for controlling the substrate temperature.

The upper end connector 212 includes a cylindrical first member 2120 connected to the upper end of the column 2112, a cylindrical second member 2121 extending concentrically with the first member 2120 at the upper side of the first member 2120, a flat third member 2122 extending substantially horizontally from the second member 2121, and a cylindrical fourth member 2123 provided at the lower surface of the third member 2122. The second member 2121 and the third member 2122 are continuously connected in an R shape. Further, a contact surface of the fourth member 2123 that makes contact with the end plate 32 is formed with a rounded corner.

The lower end connector 213 includes a first member 2131 connected to the lower end of the column 2112 and fixed to the upper surface of the ring-shaped end plate 33, a second member 2132 connected to the lower end of the column 2112, and a third member 2133 connected to the second member 2132. The second member 2132 and the third member 2133 is formed in a cylindrical shape, for example, and are configured to allow the cable 211c to pass therethrough. The second member 2132 is configured such that the cable 211c within the column 2112 is disposed within the third member 2133 disposed inside the rotary shaft 30. The lower end connector 213 is used to isolate the cable 211c disposed at the lower side of the processing space and inside the rotary shaft 30 from the processing space. The lower end connector 213 is made of, for example, quartz.

The cable 211c in the lower end connector 213 is connected to the transmitter 221 via an AD conversion board 224. The AD conversion board 224 is placed at a rotary stand 223 configured to rotate and move up or down together with the rotary shaft 30. The AD conversion board 224 converts the electrical signal (voltage) input from the substrate thermocouple 211 via the cable 211c into a digital signal, and transmits the digital signal to the transmitter 221. The transmitter 221 is configured to transmit the digital signal to the receiver 222 over radio waves by wireless transmission.

The receiver 222 is configured to receive the digital signal transmitted by the transmitter 221 and to input temperature data to the display/input device 206 or the temperature controller 64, which will be described later, based on the received digital signal.

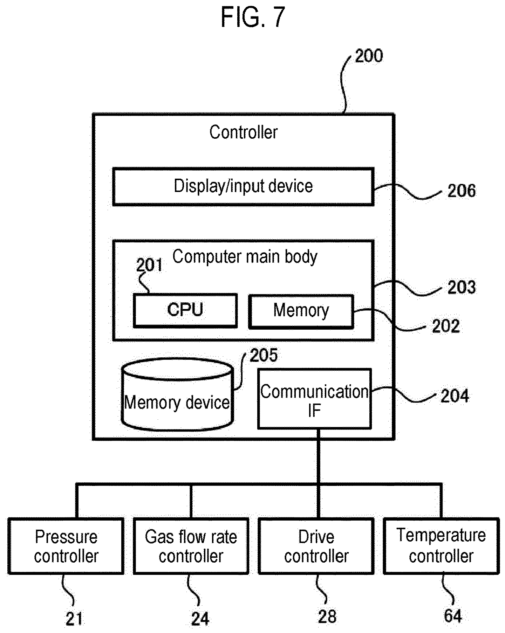

Next, a controller 200, which is a control computer serving as a control part, will be described with reference to FIG. 7.

As shown in FIG. 7, the controller 200 includes a computer main body 203 including a CPU (Central Processing Unit) 201 as a center, a memory 202, and the like, a communication IF (interface) 204 as a communicator, a memory device 205 as a memory part, and a display/input device 206 as a display (an operator or an operation part). In other words, the controller 200 includes components of a general computer.

The CPU 201 constitutes a core of the operator, executes the control program stored in the memory device 205, and executes the recipe (e.g., the process recipe) recorded in the memory device 205 according to instructions from the display/input device 206. In addition, the memory 202 as a temporary memory functions as a work area for the CPU 201.

Further, a configuration of providing the program to the computer is not limited to providing the program via the memory device 205. For example, the program may be provided without going through the memory device 205 by using communication means or unit such as the Internet or a dedicated line. The memory 202 and the memory device 205 are constituted as computer-readable recording media. Hereinafter, these will be collectively referred to as a recording medium. When the term "recording medium" is used in the present disclosure, it may include the memory 202, the memory device 205, or both.

The communication IF 204 as a communicator is electrically connected to the pressure controller 21, the gas flow rate controller 24, the drive controller 28, and the temperature controller 64 (these may be collectively referred to as sub-controllers) via communication paths. The controller 200 may exchange data regarding an operation of each component with the sub-controllers via the communication IF 204.

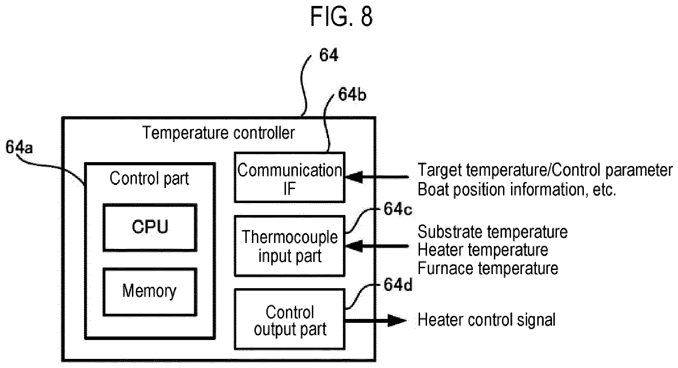

As shown in FIG. 8, the temperature controller 64 includes a control part 64a, a communication IF 64b, a thermocouple input part 64c, and a control output part 64d.

The control part 64a includes a hardware configuration as a general computer including a CPU, a memory, and the like. By executing the control program, the control part 64a executes control calculation according to a temperature control algorithm described later by using the information acquired by the communication IF 64b and the thermocouple input part 64c, and sends calculation results to the control output part 64d.

The communication IF 64b includes a wired IF for connection to the controller 200, which is a host controller, receives information such as a target temperature and control parameters from the controller 200, and transmits control calculation results and temperature information. The communication IF 64b also receives boat position information from the drive controller 28 of the elevator 26. The communication IF 64b also receives setting information set at the display/input device 206, including allocation information and the like. The received information is temporarily stored in the memory.

The thermocouple input part 64c includes a receiver 222 which is a wireless IF for connection to the transmitter 221 fixed to the boat 31. Further, the thermocouple input part 64c receives electrical signals corresponding to temperatures from the substrate thermocouple 211, the heater thermocouple 65, and the internal thermocouple 66, converts the electrical signals into digital signals, and outputs the digital signals to the control part 64a. The control output part 64d outputs a heater control signal for controlling the temperature of the heater 40 based on the calculation result received from the control part 64a.

In the following description, the temperature detected by the heater thermocouple 65 will be referred to as a heater temperature, and the temperature control in which the heater thermocouple 65 is used will be referred to as heater temperature control. Further, the temperature detected by the substrate thermocouple 211 is referred to as substrate temperature, and the temperature control in which the substrate thermocouple 211 is used is referred to as substrate temperature control. In addition, the temperature detected by the internal thermocouple 66 is referred to as a furnace temperature, and the temperature control in which the internal thermocouple 66 is used is referred to as furnace temperature control.

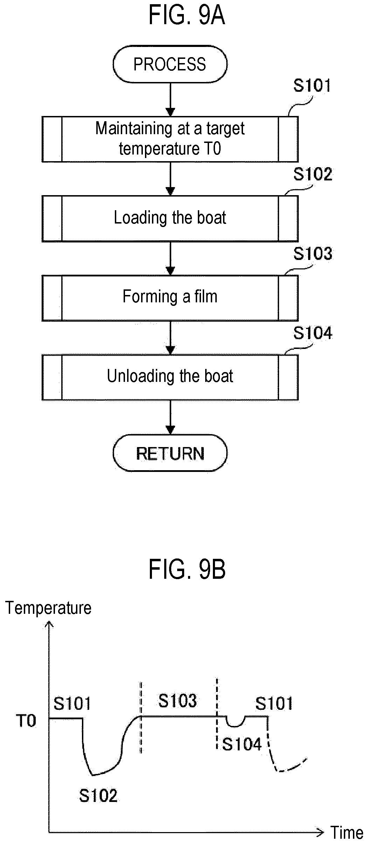

Next, an example of a substrate processing sequence performed in the substrate processing apparatus 10 will be described with reference to FIGS. 9A and 9B. In the following description, the temperature controller 64 controls the heater 40 by using the temperature detected by at least one selected from the group of the substrate thermocouple 211, the heater thermocouple 65, and the internal thermocouple 66.

Step S101 (standby step) is a process of stabilizing the temperature of the process chamber 14 at a target temperature T0 as a standby temperature (preparation temperature). In step S101, the substrates 1 are not yet loaded into the process chamber 14.

Step S102 (boat loading step) is a process of loading the substrates 1 held on the boat 31 into the process chamber 14. The drive controller 28 causes the elevator 26 to raise the boat 31 and load the boat 31 into the process chamber 14.

Before the boat 31 and the substrates 1 are loaded into the process chamber 14, the temperatures of the boat 31 and the substrates 1 are lower than the temperature of the process chamber 14 (i.e., T0). Further, as a result of loading the substrates 1 into the process chamber 14, an atmosphere (a room temperature) outside the process chamber 14 is introduced into the process chamber 14. For these reasons, as shown in FIG. 9B, the temperature of the process chamber 14 temporarily becomes lower than T0. Thereafter, under the control of the temperature controller 64, the temperature of the process chamber 14 is stabilized again at T0 after a certain period of time. In the embodiments, since the temperature is detected by using the substrate thermocouple 211 and is stabilized at the target temperature T0, the stabilization time may be made shorter than the time for stabilizing the temperature at the target temperature T0 by using the temperature detected by at least one selected from the group of the heater thermocouple 65 and internal thermocouple 66 of the related art. In FIG. 9B, the stabilization time after the substrates to be processed is loaded into the process chamber 14 and the target temperature of the next step S103 are shown to be equal to those of step S101. However, the target temperature after loading the substrates may differ depending on demanded conditions (processing temperature) in step S103. The term "processing temperature" used in the present disclosure means the temperature of the substrates 1 or the temperature of the process chamber 14. The same applies to the following description.

Step S103 (processing step) is a process of maintaining and stabilizing the temperature of the process chamber 14 at the target temperature T0 of the process temperature to perform a predetermined process on the substrates 1. The temperature controller 64 controls the heater 40 such that the temperature measured by the temperature sensor approaches the target temperature T0. For example, the temperature controller 64 controls the heater 40 such that the temperature detected by the substrate thermocouple 211 approaches the target temperature T0. At this time, the substrate thermocouple 211 is arranged in the processing space. However, since the lower end of the detector 2111 is arranged at the same position as the lower end of the support 35 of the boat 31 or at a higher position than the lower end of the support 35 of the boat 31, the height from the surface of the substrate 1 is greater than that of the support 35, the influence on processing on the surface of the substrate 1 is suppressed. Further, the column 2112 of the substrate thermocouple 211 is arranged near the support 35. In a side vie with the support 35 as a reference, the surface of the column 2112 near the processing space is arranged farther from the processing space than the surface of the support column 34 near the processing space that horizontally supports the support 35. Therefore, the surface of the column 2112 is spaced apart from the processing space, that is, the substrate 1, such that the influence on the processing on the surface of the substrate 1 is suppressed.

Step S104 (boat unloading step) is a process of unloading the processed substrates 1 together with the boat 31 from the process chamber 14. The drive controller 28 causes the elevator 26 to lower the boat 31 and unload (transport) the boat 31 to the delivery chamber 3.

In a case where unprocessed substrates 1 remain, the processed substrates 1 are removed from the boat 31 and replaced with the unprocessed substrates 1, and the series of processes of steps S101 to S104 are performed.

Steps S101 to S104 are performed after obtaining a stable state in which the temperature of the process chamber 14 is in a predetermined minute temperature range with respect to the target temperature and the temperature of the process chamber 14 is continuously maintained for a predetermined time or more.

According to the embodiments of the present disclosure, one or more of the following effects may be obtained.
(a) According to the embodiments of the present disclosure, the substrates 1 may be transferred to the boat 31 without contacting (also referred to as interfering) the substrate thermocouple 211. Further, the influence of the processing gas during substrate processing may be reduced. Accordingly, the substrate thermocouple 211 may be arranged in the processing space near the substrates 1. This makes it possible to shorten the time for the temperature to stabilize at the target temperature. As a result, it is possible to significantly shorten the time for controlling the substrate temperature in the series of processes.
(b) According to the embodiments of the present disclosure, since the substrate thermocouple 211 may be arranged to be accommodated inside the boat 31 in the side view of the support 35, it is possible to reduce the influence on the processing of the substrates 1. Accordingly, the substrate temperature may be controlled based on the temperature measured by the substrate thermocouple 211 arranged in the processing space. Therefore, it is possible to shorten the time for the temperature to stabilize at the target temperature. As a result, a temperature control time in the series of the processes may be expected to be shortened.
(c) According to the embodiments of the present disclosure, since the substrate thermocouple 211 may be brought close to the substrates 1, it is possible to accurately measure the temperature of the substrates 1 and shorten the time for the temperature to stabilize at the target temperature. As a result, it is possible to significantly shorten the control time in substrate processing.
(d) According to the embodiments of the present disclosure, since the substrate thermocouple 211 may be attached to the boat 31 and operated together with the boat 31, the temperature of the substrates 1 may be measured without being affected by temperature fluctuations due to the operation of the boat 31. For example, it is possible to perform highly accurate temperature control even in a case where fluctuations occur due to rotation.
(e) According to the embodiments of the present disclosure, since the detector 2111 and the column 2112 are made of the same material as the boat 31, the influence on the processing of the substrates 1 may be reduced. Therefore, it is possible to accurately measure the temperature of the substrates 1 and to significantly shorten the time for controlling the substrate temperature during substrate processing.
(f) According to the embodiments of the present disclosure, since the detector 2111 and the column 2112 are configured not to come into contact with the boat 31, it is possible to ensure that the detector 2111 and the column 2112 do not affect the temperature of the substrate 1. Therefore, it is possible to reduce the influence on the processing of the substrates 1 and to significantly reduce the time for controlling the substrate temperature.
(g) According to the embodiments of the present disclosure, since the transmitter 221 and the receiver 222 are arranged outside the same processing space, a wireless transmission distance may be shortened. Therefore, it is possible to perform high-quality communication that is less susceptible to disturbance and interference.
(h) According to the embodiments of the present disclosure, by arranging the transmitter 221 and the receiver 222 in close proximity, it is possible to perform wireless power supply by electromagnetic induction. Thus, a battery for a rotator may not be used, thereby improving maintainability.
(i) According to the embodiments of the present disclosure, by forming a coaxial structure between the center of the rotary shaft 30 and the center of the transmitter 221, wireless transmission may be performed without shifting the axis even when the boat 31 is rotated.
(j) According to the embodiments of the present disclosure, since the detector 2111 of the substrate thermocouple 211 is arranged at an angle, the detector 2111 may be brought closer to the substrates 1, and the substrate thermocouple 211 may be accommodated in a narrow space.

The embodiments of the present disclosure are specifically described above. However, the present disclosure is not limited to the above-described embodiments, and various changes may be made without departing from the gist thereof.

For example, the substrate processing apparatus may be applied to a semiconductor manufacturing apparatus and to an apparatus configured to process glass substrates such as LCD devices. Further, the process is not particularly limited and may be any process. The film-forming process is not particularly limited, and may be, for example, CVD, PVD, a process of forming an oxide film, a nitride film or both, a process of forming a film containing metal, and the like regardless of the film type. Further, the process may be processes other than film formation, such as an annealing process, an oxidation process, a nitriding process, a diffusion process, and the like.

According to the present disclosure in some embodiments, it is possible to arrange a temperature sensor within a processing space where a substrate is processed without affecting various processes performed on the substrate.

While certain embodiments are described above, these embodiments are presented by way of example, and are not intended to limit the scope of the disclosures. Indeed, the embodiments described herein may be embodied in a variety of other forms. Furthermore, various omissions, substitutions, and changes in the form of the embodiments described herein may be made without departing from the spirit of the disclosures. The accompanying claims and their equivalents are intended to cover such forms or modifications as would fall within the scope and spirit of the disclosures.

## Claims

1. A temperature sensor, comprising:
a temperature measurer (211b) disposed in a processing space formed between substrates (1) supported by supports (35) of a substrate support (31);
a detector (2111) in which the temperature measurer (211b) is provided; and
a column (2112) extending in a vertical direction so as to support the detector (2111) in a horizontal direction,
wherein a lower end of the detector (2111) is arranged at a same height position as a lower end of each of the supports (35) or at a higher position than the lower end of each of the supports (35), and
wherein a surface of the column (2112) near the processing space is arranged farther from the processing space than a surface of a support column (34) near the processing space, the support column (34) being configured to support each of the supports (35) in the horizontal direction.

2. The temperature sensor of Claim 1, wherein in a side view of each of the supports (35), the detector (2111) is arranged at a position included inside an outer contour of each of the supports (35).

3. The temperature sensor of Claim 1, wherein in a side view of each of the supports (35), the detector (2111) and each of the supports (35) extend to an inner side of each of the substrates (1) than a periphery of each of the substrates (1), and an amount of extension of the detector (2111) from the periphery to the inner side of each of the substrates (1) is set to be smaller than an amount of extension of each of the supports (35) from the periphery to the inner side of each of the substrates (1).

4. The temperature sensor of Claim 1, wherein in a side view of each of the supports (35), the detector (2111) and each of the supports (35) extend to an inner side of each of the substrates (1) than a periphery of each of the substrates (1), and each of the supports (35) extends to the inner side of each of the substrates (1) than the detector (2111).

5. The temperature sensor of Claim 1, wherein in a side view of each of the supports (35), a tip of the detector (2111) is arranged to be located between a tip of each of the supports (35) and a periphery of each of the substrates (1).

6. The temperature sensor of Claim 1, wherein a cross-sectional area of the detector (2111) is set to be smaller than a cross-sectional area of each of the supports (35).

7. The temperature sensor of Claim 1, wherein the temperature measurer (211b) is arranged at a periphery of each of the substrates (1).

8. The temperature sensor of Claim 1, wherein the temperature measurer (211b) is arranged near a rear surface of each of the substrates (1).

9. The temperature sensor of Claim 1, wherein the detector (2111) or the column (2112) is configured so as not to come into contact with the substrate support (31).

10. The temperature sensor of Claim 1, wherein the detector (2111) is provided for each of a plurality of heating regions configured to heat the substrates (1) and facing the substrates (1).

11. The temperature sensor of Claim 1, further comprising a lower end connector (213) provided at a lower end of the column (2112) and configured to connect the column (2112) to the substrate support (31).

12. A substrate processing apparatus, comprising:
a temperature sensor of Claim 1.

13. The substrate processing apparatus of Claim 12, further comprising:
a rotator (301) configured to rotate the substrate support (31);
a transmitter (221) connected to the temperature sensor outside a process chamber (14) in which the substrates (1) are processed, and configured to rotate together with the substrate support (31); and
a receiver (222) configured to receive a signal outputted from the transmitter (221) outside the process chamber (14).

14. A method of manufacturing a semiconductor device, comprising:
controlling a heater (40) by using a temperature detected by a temperature sensor to heat the substrates (1) to a processing temperature, the temperature sensor including:
a temperature measurer (211b) disposed in a processing space formed between substrates (1) supported by supports (35) of a substrate support (31);
a detector (2111) in which the temperature measurer (211b) is provided; and
a column (2112) extending in a vertical direction so as to support the detector (2111) in a horizontal direction,
wherein a lower end of the detector (2111) is arranged at a same height position as a lower end of each of the supports (35) or at a higher position than the lower end of each of the supports (35), and
wherein a surface of the column (2112) near the processing space is arranged farther from the processing space than a surface of a support column (34) near the processing space, the support column (34) being configured to support each of the supports (35) in the horizontal direction; and
processing the substrates (1) at the processing temperature.

15. A temperature control system, comprising:
a temperature sensor of Claim 1; and
a controller (200) configured to control a temperature of the substrates (1) by using the temperature detected by the temperature sensor.
